# EUROPEAN PATENT SPECIFICATION

(11) **EP 4 477 992 B1**
(45) Date of publication and mention of the grant of the patent: **28.10.2026**
(21) Application number: 23178969.4
(22) Date of filing: 13.06.2023
(51) Int. Cl.: G01B 11/16, G01B 11/26, H05K 13/04, H05K 13/08

(54) **PICK-AND-PLACE APPARATUS WITH FORCE MEASUREMENT AND CORRESPONDING PICKING AND PLACING METHODS**
VORRICHTUNG ZUR AUFNAHME UND PLATZIERUNG MIT KRAFTMESSUNG UND ENTSPRECHENDE AUFNAHME- UND PLATZIERUNGSVERFAHREN
APPAREIL DE SAISIE ET DE PLACEMENT AVEC MESURE DE FORCE ET MÉTHODES CORRESPONDANTES DE SAISIE ET DE PLACEMENT

(43) Date of publication of application: 18.12.2024
(73) Proprietor: Nexperia B.V., 6534 AB Nijmegen (NL)
(72) Inventor: Liu, Yazhao, The Hague (NL); Goosen, Johannes Frans Lodewijk, Delft (NL); van der Veen, Gijs, 6534AB Nijmegen (NL)
(74) Representative: Pjanovic, Ilija

(56) References cited:
- GB-A- 2 242 518
- JP-A- 2012 146 762
- US-A- 5 285 946

## Description

### FIELD

Aspects of the present disclosure relate to a pick-and-place apparatus for picking an electronic component from a first carrier, and for placing the electronic component onto a second carrier. Aspects of the present disclosure further relate to a method for picking an electronic component from a first carrier, and to a method for placing an electronic component onto a second carrier.

### BACKGROUND

Pick-and-place apparatuses are known devices by which an electronic component can be picked from a first carrier and can be placed onto a second carrier. An exemplary application of a pick-and-place apparatus is to pick semiconductor dies from a semiconductor wafer and to place the picked semiconductor dies onto a printed circuit board. In this case, the semiconductor wafer or carrier that supports it is the first carrier and the printed circuit board the second carrier.

Typically, the pick-and-place apparatus comprises a pickup unit by which the electronic components are picked. This same unit, or another unit, may be used for placing the picked electronic components onto the second carrier.

A known pickup unit uses a vacuum force for picking up electronic components. In these units, the electronic components are sucked against a nozzle or tip. For placing the electronic components onto the second carrier, the vacuum is removed and/or gas is expelled through the nozzle or tip to push the electronic component away from the pickup unit.

When arranging electronic components using the pickup unit as described above, a problem may exist in that the force by which the electronic component is arranged onto the second carrier is not constant during the process of arranging a plurality of electronic components. Typically, an adhesive or other material by which the electronic component is fixedly and electrically attached to the printed circuit board, such as solder, is arranged onto the second carrier in predefined quantities. When pressing the electronic component into or onto the adhesive, some of the adhesive, which may be in an at least partially liquid form when arranging the electronic components, may flow out from underneath the electronic component. The amount of flow-out, and therefore the amount of adhesive that remains underneath the electronic component, depends inter alia on the force by which the electronic components are arranged onto the second carrier. Consequently, when this force is not constant, variations may occur in the amount of adhesive that is arranged in between the electronic components and the second carrier. This will introduce a variation in the height position of the electronic components over the second carrier. For some applications, such as a printed circuit board provided with a matrix of LEDs, a variation of this sort is unwanted.

In addition to the variation in the height position of the electronic components, a variation in the orientation of the electronic components relative to the second carrier may occur.

Pickup units are generally moving devices subject to variation in position and orientation. For example, the position at which a pickup unit may place an electronic component may be slightly different from an intended position. Similarly, the orientation in which a pickup unit may place an electronic component may be slightly different from an intended orientation. These variations may also be unwanted. Similar problems may occur when arranging electronic components onto the second carrier.

JP 2012-146762 A discloses a pick-and-place apparatus comprising a pickup unit for picking an electronic component and placing it onto a printed circuit and a load sensor for measuring an impact force on electronic components during mounting.

Determining the orientation and position of the pickup unit is generally complicated due to the large number of components in the pick-and-place apparatus. Furthermore, as the pickup unit is moving during operation, some known techniques for determining the orientation and/or position of the pickup unit cannot be used.

### SUMMARY

According to aspects of the present disclosure, a pick-and-place apparatus is provided in which the abovementioned problems are addressed.

According to a first aspect of the present invention, which is defined in claim 1, a pick-and-place apparatus is provided for picking an electronic component from a first carrier and for placing the electronic component onto a second carrier. The apparatus comprises a pickup unit for picking an electronic component and a pickup unit for placing the electronic component, which may be the same pickup unit as the pickup unit used for picking the electronic component. An outer surface of the pickup unit(s) is provided with a diffraction grating that comprises a repetition, in a first direction, of a pattern unit. The apparatus further comprises at least one collimated light source configured for emitting collimated light onto the diffraction grating when picking an electronic component from the first carrier and/or when placing an electronic component onto the second carrier. The system additionally comprises a sensor system for sensing a position of an *n*-th order light beam from the diffraction grating, wherein |*n*| > 0, and a processor configured for determining a change in length of the pickup unit in the first direction at a position of the diffraction grating based on the sensed position of the *n*-th order light beam when picking an electronic component from the first carrier and/or when placing an electronic component onto the second carrier.

In short, according to the first aspect, a shift in the *n*-th order light beam is used for detecting a change in length of the pickup unit in a direction perpendicular to the diffraction grating. For example, when the pickup unit is pressed against a semiconductor die during the process of picking up a semiconductor die, it will deform slightly. More in particular, in a first direction perpendicular to a surface of the semiconductor die, the length will decrease, and in a second direction perpendicular to this first direction, the length may increase. By arranging the diffraction grating perpendicular either to the first or second direction, it will become possible to determine the corresponding change in length by inspecting the *n*-th order light beam. This is reflected in equations 1 and 2 that indicate that the diffraction angle will change if distance *d* changes due to the length change.

It is noted that by inspecting the *n*-th order light beam, the length change at the position of the diffraction grating can be determined. The length change need not be uniformly distributed over the pickup unit nor is the force exerted on the pickup unit causing the change restricted to one particular direction. In general, if the correlation between the cause of the length change and the length change itself is known, for example by having a physical model for the pickup unit, it may be possible to determine the cause, i.e. the force or strain, by monitoring the *n*-th order light beam.

The processor can further be configured to determine, based on the determined change in length, a first force exerted by the pickup unit on the electronic component and/or the first carrier when picking the electronic component from the first carrier, and/or a second force exerted by the pickup unit on the electronic component and/or the second carrier when placing the electronic component onto the second carrier. The force exerted by the pickup unit on the electronic component or the first carrier is generally the inverse of the counter force exerted by these components on the pickup unit. Similar considerations hold for the second force.

To determine the first and second forces, a physical model of the pickup unit may be used. Such model could for example describe how the pickup unit deforms as a result of forces exerted on the outer surface(s) of the pickup unit. Such physical model may be tensor-based.

The apparatus may further comprise a movable support unit, such as a robotic arm, on which the pickup unit is mounted. In this case, the processor could be configured to adjust a force exerted by the movable support unit through the pickup unit on the electronic component and/or first carrier when picking the electronic component from the first carrier, and/or to adjust a force exerted by the movable support unit through the pickup unit on the electronic component and/or second carrier when placing the electronic component onto the second carrier. To this end, the processor could control the movable support unit directly. Alternatively or additionally, the processor could control a supporting unit on which the first carrier or second carrier is arranged. For example, by moving the supporting unit relative to the movable support unit it becomes possible to adjust the force exerted during component picking and/or placing.

The processor can be configured to determine the first force and/or the associated change in length during picking of an electronic component, compare the determined first force and/or the associated change in length to a first reference force and/or an associated first reference change in length, and generate a first comparison result. Additionally or alternatively, the processor can be configured to determine the second force and/or the associated change in length during placing of an electronic component, compare the determined second force and/or the associated change in length to a second reference force and/or an associated second reference change in length, and generate a second comparison result.

The first and second comparison result can be used in a manual or automatic feedback control loop. In an automatic feedback control loop, the processor can be configured to adjust, in dependence of the first comparison result and/or second comparison result, the force exerted by the movable support unit through the pickup unit on the electronic component and/or first carrier when picking the electronic component from the first carrier, and/or the force exerted by the movable support unit through the pickup unit on the electronic component and/or second carrier when placing the electronic component onto the second carrier.

In a manual feedback control loop, the processor can be configured to output a signal in correspondence with the first and/or second comparison result to a user. In this case, the processor can be configured to receive a user input for adjusting said force exerted by the movable support unit through the pickup unit on the electronic component and/or first carrier when picking the electronic component from the first carrier, and/or adjusting said force exerted by the movable support unit through the pickup unit on the electronic component and/or second carrier when placing the electronic component onto the second carrier.

The pick-and-place apparatus may further comprise a memory that is operatively coupled to the processor and that holds a look-up table that correlates a change in length of the pickup unit in the first direction at the position of the diffraction grating to a value of a force and/or strain exerted on the pickup unit associated with the length contraction. Using a lookup table reduces the computational strain or time for determining the value of the force and/or strain exerted on the pickup unit associated with the length contraction.

The sensor system may be further configured for sensing an *m*-th order light beam from the diffraction grating, wherein *m* is different from 0 and *n.* In this case, the processor can be configured for determining a change in length of the pickup unit in the first direction at a position of the diffraction grating based on the sensed *n*-th order light beam, and the sensed *m*-th order light beam when picking an electronic component from the first carrier and/or when placing an electronic component onto the second carrier. Preferably, *m* is equal to *-n,* and *n* preferably equals 1.

The processor can be configured to determine an orientation of the pickup unit when picking an electronic component from the first carrier and/or when placing an electronic component onto the second carrier based on the sensed *n*-th order light beam and the sensed *m*-th order light beam.

If the orientation of the pickup unit is fixed, monitoring a single higher order light beam from the diffraction grating can be sufficient for determining the length change provided that this light beam is not a 0-th order light beam.

In some cases, the orientation of the pickup unit may change, for example as a result of the pickup unit making physical contact with the electronic component, first carrier, or second carrier.

The pick-and-place apparatus may further comprise at least one orientation unit for changing an orientation of the at least one collimated light source, wherein the processor is configured for controlling the at least one orientation unit in dependence of the determined orientation and/or position for ensuring that light from the at least one collimated light source impinges the diffraction grating during picking of each of the plurality of electronic components to be picked from the first carrier, and/or for ensuring that light from the at least one collimated light source impinges the diffraction grating during placing of each of the plurality of electronic components to be placed onto the second carrier.

The first carrier can be a semiconductor wafer or a carrier supporting the semiconductor wafer in which case the electronic components to be placed and arranged are semiconductor dies from that semiconductor wafer. Furthermore, the second carrier can be a printed circuit board. Alternatively, the electronic components can be packaged semiconductor dies or devices.

The diffraction grating can either be a transmissive or a transparent diffraction grating.

The at least one collimated light source may comprise a first collimated light source configured for emitting collimated light onto the diffraction grating when picking an electronic component from the first carrier, and a second collimated light source configured for emitting collimated light onto the diffraction grating when placing an electronic component onto the second carrier. In this case, the sensor system may comprise a first sensor subsystem for sensing light beams from the diffraction grating when picking an electronic component from the first carrier, and a second sensor subsystem for sensing light beams from the diffraction grating when placing an electronic component onto the second carrier. The sensor system, or the first and second sensor subsystems, may each comprise a respective sensor for sensing a respective light beam among the 0-th order, *m*-th order, and *n*-th order from the diffraction grating.

According to a second aspect of the present invention, which is defined in claim 14, a method for picking an electronic component from a first carrier is provided. This method comprises the steps of i) picking, using a pickup unit, an electronic component from the first carrier, wherein an outer surface of the pickup unit is provided with a diffraction grating that comprises a repetition, in a first direction, of a pattern unit, ii) emitting collimated light onto the diffraction grating when picking an electronic component from the first carrier, iii) sensing a position of an *n*-th order light beam from the diffraction grating, wherein |*n*| > 0, and iv) determining a change in length of the pickup unit in the first direction at a position of the diffraction grating based on the sensed position of the *n*-th order light beam when picking the electronic component from the first carrier.

According to a third aspect of the present invention, which is defined in claim 15, a method for placing an electronic component from a second carrier is provided. This method comprises the steps of i) placing, using a pickup unit, an electronic component from the second carrier, wherein an outer surface of the pickup unit is provided with a diffraction grating that comprises a repetition, in a first direction, of a pattern unit, ii) emitting collimated light onto the diffraction grating when placing an electronic component onto the second carrier, iiii) sensing a position of an *n*-th order light beam from the diffraction grating, wherein |*n*| > 0, and iv) determining a change in length of the pickup unit in the first direction at a position of the diffraction grating based on the sensed position of the *n*-th order light beam when placing the electronic component onto the second carrier.

### DESCRIPTION OF THE DRAWINGS

So that the manner in which the features of the present disclosure can be understood in detail, a more particular description is made with reference to embodiments, some of which are illustrated in the appended figures. It is to be noted, however, that the appended figures illustrate only typical embodiments and are therefore not to be considered limiting of its scope. The figures are for facilitating an understanding of the disclosure and thus are not necessarily drawn to scale. Advantages of the subject matter claimed will become apparent to those skilled in the art upon reading this description in conjunction with the accompanying figures, in which like reference numerals have been used to designate like elements, and in which:
Figure 1 illustrates a transmissive diffraction grating (top) and reflective diffraction grating (bottom);
Figure 2 schematically illustrates a pick-and-place apparatus in accordance with the present disclosure;
Figure 3 illustrates an embodiment of a pick-and-place apparatus in accordance with the present disclosure;
Figures 4A-4D illustrate different detailed views of the apparatus of figure 3;
Figure 5 illustrates a mold for making the pickup unit of the apparatus of figure 3;
Figure 6 illustrate the various rotations to be determined by the system of figure 2; and
Figure 7 illustrates a method by which the angle of a light beam can be detected in accordance with an aspect of the present disclosure.

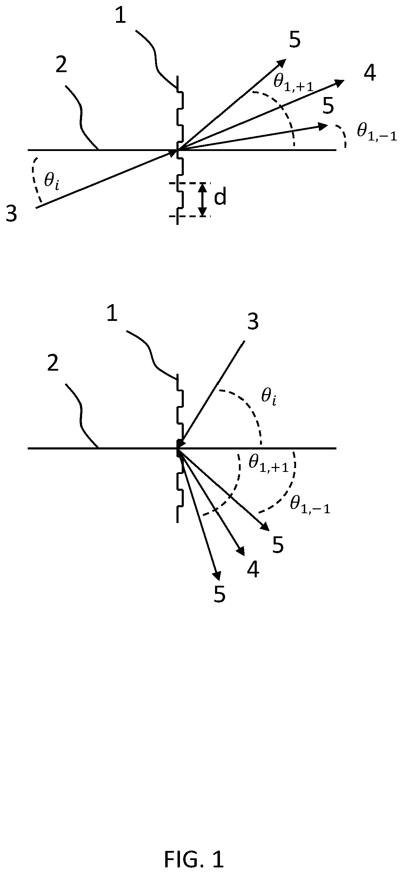

Figure 1 illustrates a transmissive (top) and reflective (bottom) diffraction grating pattern. In both cases, a collimated light beam 3 is incident on a diffraction grating 1 at an angle *θᵢ* with respect to normal 2. Due to diffraction, higher order light beams 5 are generated in addition to a 0-th order light beam 4.

In figure 1, two higher order light beams are illustrated, namely two first-order light beams that make an angle with normal 2 of *θₘ* = *θ*_{1,+1} and *θₘ* = *θ*_{1,-1}. Both angles comply with equation 1, which for the transmissive and reflective diffraction gratings results in: ${sinθ}_{1 , + 1} = {sinθ}_{i} + \frac{λ}{d}$ Eq. 3 ${sinθ}_{1 , - 1} = {sinθ}_{i} - \frac{λ}{d}$ Eq. 4

It can be seen that if distance d changes, so will the angles *θ*_{1,+1} and *θ*_{1,-1}. Furthermore, if the diffraction grating changes orientation, light beams corresponding to the +1-th and -1-th order will change the paths along which they propagate through space. According to an aspect of the present disclosure, by arranging a diffraction grating on a device, it becomes possible to monitor the orientation and length change of the device. The Applicant has realized that this particular manner of monitoring is particularly effective in pick-and-place apparatuses in which electronic components are to be picked and placed with great accuracies. Furthermore, such a contactless measurement technique is particularly useful when inspecting the pickup units.

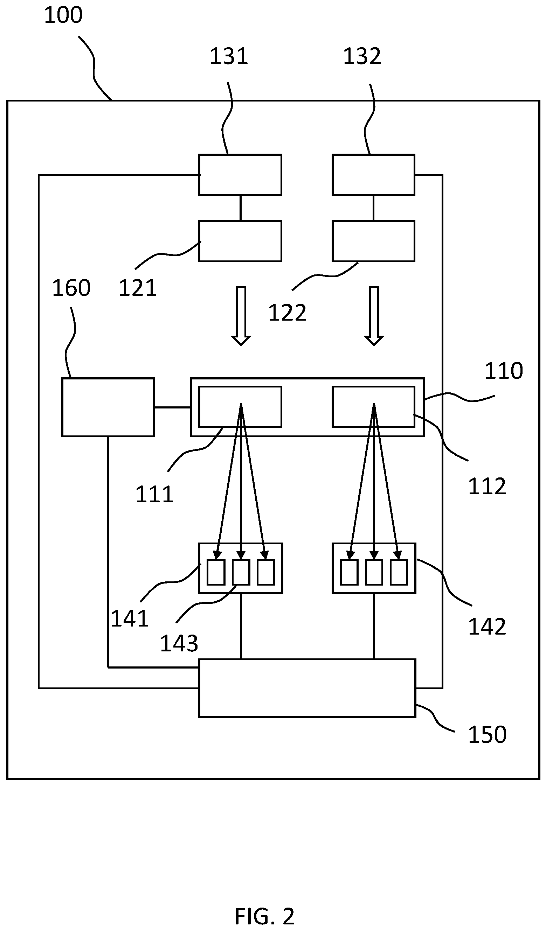

Figure 2 schematically illustrates a pick-and-place apparatus 100 in accordance with the present disclosure. The abovementioned device may for example correspond to a pickup unit of this pick-and-place apparatus.

Apparatus 100 comprises a pickup unit 110, wherein an outer surface of pickup unit 110 is provided with a first diffraction grating 111 and a second diffraction grating 112. Each pattern 111, 112 comprises a repetition of a respective pattern unit. The pattern units for diffraction gratings 111, 112 may differ from each other. For example, the characteristic distance d and/or the construction of diffraction gratings 111, 112 may differ. Furthermore, the direction in which the pattern units are repetitively arranged may be different for patterns 111, 112.

Apparatus 100 further comprises a first collimated light source 121 and a second collimated light source 122 of which the orientation may be changed using respective orientation units 131, 132.

Apparatus 100 comprises respective sensor systems 141, 142 for sensing the light beams from diffraction gratings 111, 112, respectively. Each sensor system 141, 142 comprises three sensors 143, one for sensing the 0-th order, one for sensing the +1-th order, and one for sensing the -1-th order.

Apparatus 100 comprises a processor 150 configured for processing the signals from sensor systems 141, 142. Processor 150 controls a movable support unit 160 on which pickup unit 110 is mounted.

Processor 150 may form, together with collimated light sources 121, 122, and sensor systems 141, 142, a system for determining an orientation of pickup unit 110 as will be explained below. Furthermore, more light sources and sensor systems may be provided, for example for determining orientation, position, and/or length change of pickup unit 110 at various positions in apparatus 100, for example at a position at which electronic components are picked from a first carrier, or a position at which electronic components are placed onto a second carrier. In addition, embodiments are possible in which less or more diffraction gratings are used on the surface of pickup unit 110.

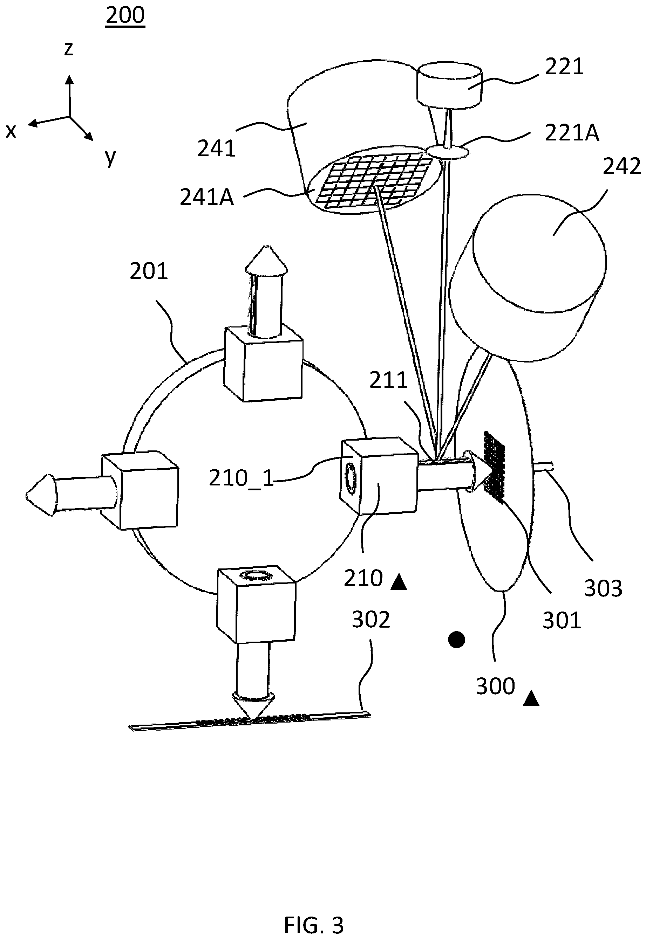

Figure 3 illustrates an embodiment of a pick-and-place apparatus 200 in accordance with the present disclosure. It comprises carousel 201 on which four pickup units 110 are mounted. Also shown is a semiconductor wafer 300 comprising a plurality of semiconductor dies 301 that are to be arranged onto a second carrier 302. Semiconductor wafer 300 is arranged on a film or foil and is further supported by a stage (not shown) that is capable of being moved in directions z, y shown in figure 3. In this case, the film or foil, or the film frame carrier to which the film or foil is connected acts as a first carrier. Similarly, second carrier 302 is supported by a stage (not shown) that is capable of being moved in directions x, y shown in figure 3. To move the abovementioned stages, suitable electric motors can be used.

The process of picking and placing semiconductor dies 301 will be explained next.

To pick up a semiconductor die 301 from wafer 300, the stage supporting semiconductor wafer 300 is moved to bring a next semiconductor die on wafer 300 into alignment with pickup unit 210_1.

To pick up semiconductor die 301, pickup unit 210 and wafer 300 are moved towards each other. This can be achieved by driving pickup unit 210 to move in a direction opposite to the x-direction, for example using movable support unit 160 shown in figure 2, and/or by moving the stage that supports semiconductor wafer 300 in the x-direction.

A needle like element 303 is provided at the backside of semiconductor wafer 300. This element can be moved in the x-direction causing it to punch or push onto the foil thereby resulting in the semiconductor die 301 at this position at least partially detaching from a remainder of wafer 300.

Pickup unit 210 is provided with a tip through which a suction force can be exerted. As a result of this force, semiconductor die 301 becomes attached to the tip of pickup unit 210. Next, carousel 201 is rotated clockwise to bring the semiconductor die 301 that was picked up last into alignment with second carrier 302. Typically, a second carrier 302 is provided with discrete spots of adhesive, such as solder. Using the stage supporting second carrier 302, second carrier 302 is moved to bring an empty position on second carrier 302 into alignment with pickup unit 210. Once in alignment, pickup unit 210 and second carrier 302 are moved towards each other in the z-direction. Again, this movement can be achieved by moving pickup unit 210 and/or by moving second carrier 302. When pickup unit 210 is sufficiently close to second carrier 302, the suction force in the tip of pickup unit 210 is removed and/or pressure is applied to the tip to push semiconductor die 301 away from the pickup unit. It should be noted that while a semiconductor die is arranged on second carrier 302, a new semiconductor die can be picked from semiconductor wafer 300. This is possible thanks to the arrangement of multiple pickup units 210 on carousel 201.

During the picking and placing process, pickup unit 210 may physically contact a semiconductor die 301. For example, pickup unit 210 may contact the semiconductor die before it is picked. In this case, the semiconductor die is arranged in between pickup unit 210 on one side and the foil and needle like element 303 on the other side. Similarly, during placing of semiconductor die 301, pickup unit 210 may push semiconductor die 301 against second carrier 302.

To enable a uniform pick-and-place process, the force that pickup unit 210 exerts a force onto semiconductor dies 301 is ideally constant throughout the process, and from wafer to wafer. Similarly, the orientation of pickup unit 210 is preferably constant and/or known. To this end, pick-and-place apparatus 200 can be provided with a system for determining an orientation of pickup unit 210. This system uses a diffractive grating 211 that is arranged on an outer surface of pickup unit 210. A collimated light source comprising a light source 221 and collimating lens 221A generates a collimated beam of light that impinges diffraction grating 211 perpendicularly. The +1-th order light beam and the -1-th order light beam that are generated by diffraction grating 211 are sensed using light sensors 241, 242 that each comprise a sensor surface 241A. More particularly, light sensors output coordinates on sensor surface 241A at which a light beam is detected.

In figure 3, pick-and-place apparatus 200 comprises a single carousel 201. Consequently, semiconductor dies 301 are picked and arranged from the same side and using the same pickup unit. In some applications, the orientation of semiconductor 301 should be flipped in between picking semiconductor dies 301 and placing semiconductor dies 301. Examples are flip-chip applications.

Flipping the orientation of semiconductor dies 301 can be achieved using a second carousel that is arranged next to carousel 201. The second carousel will then receive semiconductor dies 301 from carousel 201. More in particular, pickup units on the second carousel, which are similar to those on carousel 201, will receive semiconductor dies 301 from carousel 201. The pickup units on the second carousel will then perform the final placing of semiconductor dies 301 on the second carrier 302.

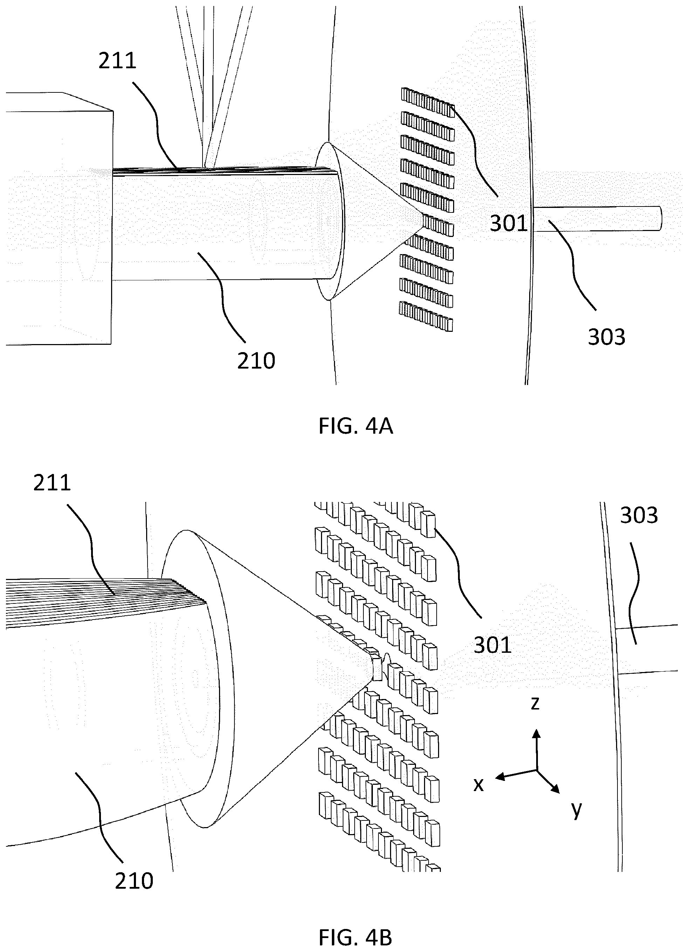

A processor, such as processor 150 in figure 2, is used for collecting the data from sensors 241 and 242, and for determining a change in length at the position at which the collimated light beam impinges on diffraction grating 211. This is shown in more detail in figures 4A-4D.

As shown in figure 4B, pickup unit 210 contacts semiconductor die 301, for example because it is pushed towards pickup unit 201 by needle like element 303. The force exerted on pickup unit 210 will cause the latter to deform.

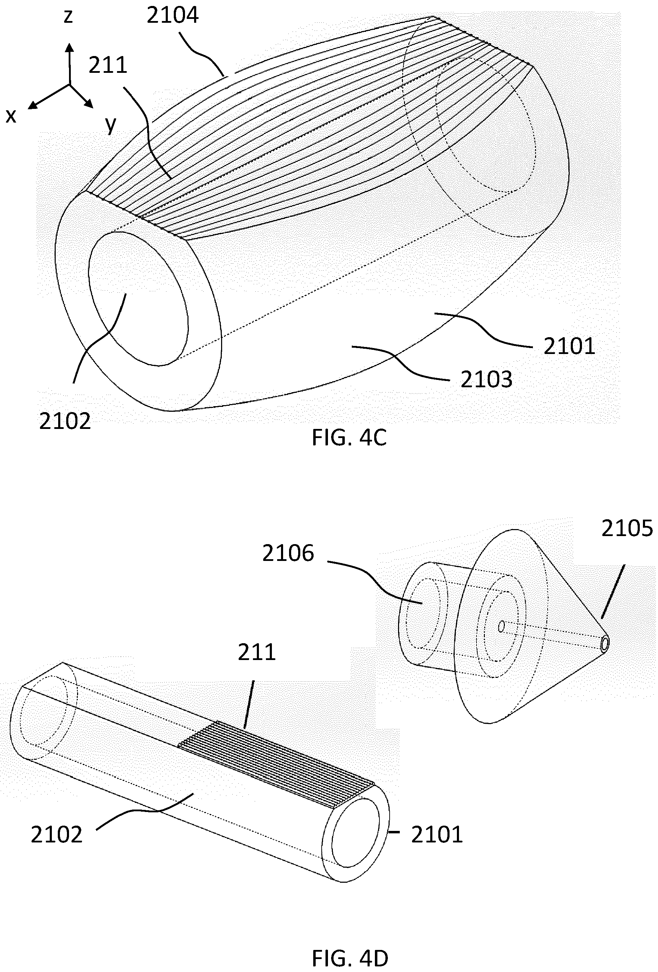

Pickup unit 210 is shown in more detail in figures 4C and 4D. Pickup unit 210 comprises a deformable shaft 2101 having a central bore 2102. An outer surface 2103 of pickup unit 210 comprises a flat portion 2104 at which it is provided with diffraction grating 211. This pattern comprises a plurality of pattern units that are elongated in the x-direction and which are repeated in the y-direction. It is noted that figure 4C illustrates elongated shaft 2101 and diffraction grating 211 in a deformed state.

Pickup unit 210 further comprises tip 2105 that is provided with a central bore 2106. Tip 2105 is typically fastened or attached to shaft 2101 such that central bore 2102 and central bore 2106 are aligned. By reducing pressure inside central bore 2101, a suction force can be generated at the end of tip 2105. Similarly, by increasing the pressure inside central bore 2102, semiconductor dies 301 can be pushed away from tip 2105.

Several different techniques are possible to attach tip 2105 to shaft 2101. For example, a transition fit or an adhesive such as glue can be used. Alternatively, shaft 2101 and tip 2105 are integrally formed.

Figure 4D illustrates shaft 2101 when no external forces are applied to pickup unit 210, while figure 4C illustrates shaft 2101 when an external force in the x-direction is applied to pickup unit 210. As a result of this force, shaft 2101 is deformed in the x-direction and in the y-direction. More particularly, the length of shaft 2101 in the x-direction is reduced while a width of shaft 2101 in the y-direction is increased.

In figures 4C, 4D, diffraction grating 211 has its elongated pattern units arranged with their longitudinal axes in the x-direction. Consequently, due to the deformation in the y-direction, the effective value for distance d in equations 3 and 4 changes, i.e. it becomes larger. This causes the +1 and -1 order light beams to move away from each other. This change can be detected by sensors 241, 242. More particularly, using the position data from sensors 241, 242, the processor can determine the deformation at the position in diffraction grating 211 where the collimated light beam impinges diffraction grating 211. Using a physical model of pickup unit 210, this deformation can be used for computing a force exerted on tip 2105. This force is related to a counterforce that is exerted on semiconductor die 301.

Although shown as pattern units elongated in the x-direction, diffraction grating 211 could equally use pattern units that are elongated in the y-direction. However, such arrangement would result in the higher order light beams being generated in the x-z plane. In a pick-and-place apparatus, there is generally less space available for arranging the required light source and sensors in this plane than in the z-y plane.

Having established a deformation in pickup unit 210 and/or force exerted on pickup unit 210, the processor may control the drive used for bringing pickup unit 210 and semiconductor 301 into physical contact. For example, when pickup unit 210 is driven by a movable support unit 160 as shown in figure 2, which can be in the form of a linear motor, the processor may control this unit to exert less or more force onto pickup unit 210. This adjustment may be performed while picking up the semiconductor die 301. Alternatively, the adjustment is made in respect of a semiconductor die 301 to be picked up next. In this manner, the force exerted on the semiconductor dies 301 during pick up can be controlled in a uniform manner.

Although described in connection with picking a semiconductor die 301, a similar approach can be used when placing a semiconductor die 301 onto second carrier 302. This generally requires the use of a separate collimated light source and separate sensors. As the components are preferably arranged in the z-y plane, it is preferred that the light sensor emits a collimated light beam in the x-direction onto diffraction grating 211. The sensors for detecting the resulting higher order diffraction beams are then arranged next to the light sensor in the y-direction and the direction opposite to the y-direction. In figure 3, the position of the light source and light sensors for monitoring during component placement are indicated using a circle, and a pair of triangles, respectively.

In the pick-and-place apparatus described in conjunction with figures 3, 4A-4D, a movable support unit was described to move pickup unit 210 in a single direction. The present disclosure is not limited to such movable support unit. In other embodiments, a robotic arm is used on which the pickup unit is mounted.

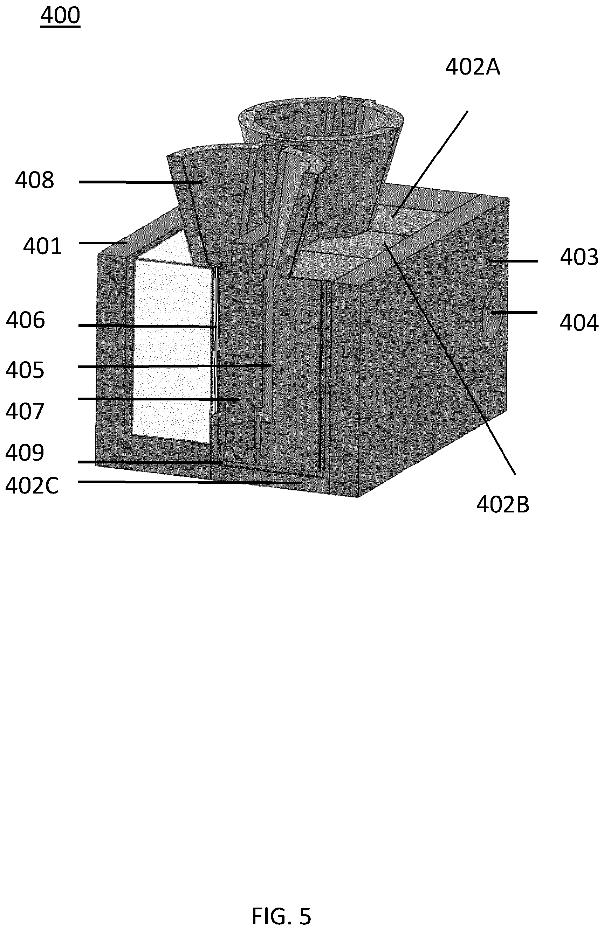

Figure 5 illustrates a mold 400 for making pickup unit 210. Mold 400 comprises a holding box 401 in which several mold parts 402A-402C can be arranged. To this end, holding box 401 may comprise a sealing door 403 that can be fixed to a remainder of holding box 401 using a sealing screw 404. By opening sealing door 403, mold parts 402 can be removed from holding box 401 as well as the at least partially solidified pickup units 210.

Typically, mold parts 402A and 402B are mirrored copies of each other. Furthermore, Mold part 402A and mold part 402C are copies of each other. It is noted that figure 5 does not show the mold part that is complementary to mold part 402C.

An inner wall of mold parts 402A, 402B, 402C defines an outer surface of pickup unit 210. These walls also define a mold cavity 405. Inside mold cavity 405, a diffraction unit 406 is arranged, which comprises a body having an outer surface on which a diffraction grating 211 is provided. Diffraction unit 406 is arranged inside mold cavity 405 such that diffraction grating 211 is facing the inner walls of mold parts 402A, 402B, 402C.

A shaft 407 is arranged in mold cavity, wherein shaft 407 is configured for realizing central bore 2102. Furthermore, at an upper surface, mold parts 402A, 402B, 402C jointly form a pair of pouring cups 408. After closing holding box 401, liquid molding material is poured into pouring cups. Gas inside mold cavity may escape mold cavity through a gas venting channel 409. The molding material can for example comprise one or more resins and/or polymers.

Once at least partially solidified, holding box 401 is opened to allow mold parts 402A-402C, shaft 406, and pickup unit 210 to be removed. Optionally, additional processing can be performed on pickup unit 210 to further cure pickup unit 210.

Using the method described above, a pickup unit 210 is obtained in which diffraction grating 211 is fixedly attached to deformable shaft 210. Other options exist by which a diffraction grating 211 can be formed on or in deformable shaft 210. For example, a pattern corresponding to the inverse of the diffraction grating can be formed on an inner wall of a mold part 402A-402C. In such case, the diffraction grating is formed during the molding process. Other imprinting techniques are possible by which a diffraction grating is pressed into the deformable shaft.

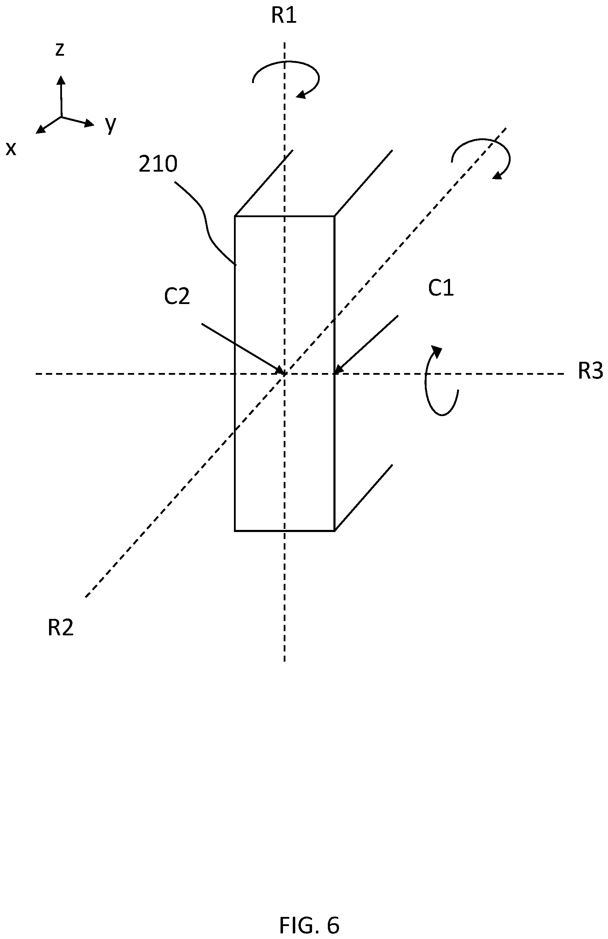

In the description so far, it was assumed that pickup unit 210 has a constant orientation during component pick up and during component placement. Under these conditions, it suffices to measure a single higher order diffraction beam to determine the force or strain on pickup unit 210. However, this assumption may not always hold, in particular because pickup unit 210 may be configured as a moving unit. Mechanical tolerances and clearances may cause pickup unit 210 to display yaw, tilt, and roll as explained in connection with figure 6. In this figure, a diffraction grating is assumed that consists of pattern units that are elongated in the z-direction, and that are repeated in the x-direction. In figure 6, yaw is defined as a rotation about the z-axis, tilt as a rotation about the x-axis, and roll as a rotation about the y-axis.

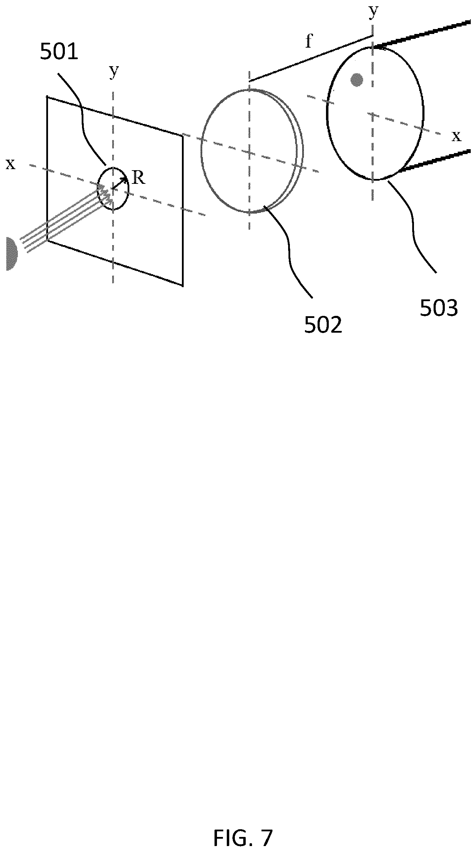

Figure 6 further illustrates a center point C1 of the diffraction grating and a center point C2 of the pickup unit 210 as a whole. Here, it is noted that figure 7 illustrates a cross-sectional view of pickup unit 210 in which a cross-section in the z-y plane is shown halfway the pickup unit 210 in the x-direction.

The method for determining the orientation of pickup unit 210 will now be explained based on three possible assumptions regarding the movement of pickup unit 210.

In a first case, it is assumed that the orientation of pickup unit 210 may change due to yaw, roll, and tilt relative to center point C1 that is fixed in space. In this case, the collimated light source emits a collimated light beam onto center point C1. The higher order light beams created by diffraction are then captured using sensors. More in particular, in this case, two sensors will suffice for uniquely determining the orientation of pickup unit 210. The orientation may correspond to a yaw angle, a tilt angle, and a roll angle.

When two sensors are used, the position data obtained from these sensors comprise 4 independent parameters, e.g. x1, x2, y1, and y2, wherein xn and yn represent the position on a sensor surface at which sensor n detects a higher order diffraction beam. The orientation of pickup unit 210 comprises three degrees of freedom, being the yaw, tilt, and roll angle.

Using position data from two sensors, the processor can determine the orientation of pickup unit 210. To this end, it may use the known position and orientation of the two sensors, for example with respect to center point C1. In addition, the orientation of the light source relative to center point C1 may be known and used by the processor to determine the orientation of pickup unit 210.

In a second case, it is assumed that the orientation of pickup unit 210 may change due to yaw, roll, and tilt relative to center point C2 that is fixed in space. In this case, a positional relationship between center points C1 and C2 is known. This information is used in addition to the previously mentioned information by the processor to determine the orientation of pickup unit 210. Again, three degrees of freedom exist allowing the orientation to be uniquely defined using two sensors.

In a third case, it is assumed that center points C1 and C2 may both change position in space. In this case, six degrees of freedom exist so that additional information is required to determine both position and orientation of pickup unit 210. This additional information can be obtained by using a third sensor that senses the 0-th order diffraction beam. In this case, the processor uses the position data from the first, second, and third sensor for determining the position and orientation of pickup unit 210.

In the second and third cases above, it was assumed that the collimated light source was able to emit a collimated beam of light onto the diffraction grating. To this end, an orientation unit can be provided to change an orientation of the collimated light source. The processor can then be configured to control an orientation of the collimated light source. Furthermore, the processor may implement a feedback control loop in which the orientation of the light source is changed based on a determined position and/or orientation of the device to ensure that the collimated light source keeps emitting collimated light onto the center point of the diffraction grating.

Figure 7 illustrates an advantageous method for determining an angle of a diffraction beam. In this figure, the diffraction beam is passed through a pinhole 501 having a radius R and an objective lens 502 before hitting sensor 503 at a position x, y. A distance between objective lens 502 and sensor 503 corresponds to a focal length f.

It is known that light that passes through a circular aperture is subject to diffraction. More in particular, an Airy pattern is created comprising a central Airy disc that is surrounded by a plurality of concentric circles. The angle at which the first intensity minimum occurs, measured from the direction of the incoming diffraction beam, is approximately given by: $sin θ \approx 1.22 \frac{λ}{2 R}$ Eq. 5 wherein R is the radius of the aperture, which corresponds to the radius of pinhole 501 when light is passed through a pinhole 501, and which corresponds to half the numerical aperture when light is passed through objective lens 502.

When using only a pinhole 501, the diffraction grating on the surface of sensor 503 has a typical Airy patten, i.e. a center bright disc surrounded by a group of bright and dark circles. The size of the Airy disc relies on the distance between pinhole 501 and the sensor surface of sensor 503. When the incident light beam has a weak intensity, only the central bright disc can be observed clearly. The coordinates of the Airy disc on the surface of sensor 503, e.g. x and y, rely on the incident angle of the light beam towards the transverse and vertical direction respectively. When the incident angle changes, even with an expanded beam width due to divergence, the coordinates change accordingly.

When using only objective lens 502, a clear light spot of the Airy disc can be observed on the focal plane. The coordinates of the Airy disc center on the focal plane change according to the changes in the incident angle. It should be noted that in some embodiments, both a pinhole 501 and an objective lens 502 are used.

To calibrate this system, known incident angles and the coordinates of the corresponding Airy disc are first recorded in the x and y directions, respectively, as basic data for calibration. These data may be stored in the form of a lookup table.

In the above, the present invention has been described using detailed embodiments thereof. However, the present invention is not limited to these embodiments. Instead, various modifications are possible without departing from the scope of the present invention which is defined by the appended claims.

## Claims

1. A pick-and-place apparatus (200) for picking an electronic component (301) from a first carrier and for placing the electronic component onto a second carrier (302), the apparatus comprising:
a pickup unit (210) for picking the electronic component and for placing the electronic component, wherein an outer surface of the pickup unit is provided with a diffraction grating (211) that comprises a repetition, in a first direction, of a pattern unit;
at least one collimated light source configured for emitting collimated light onto the diffraction grating when picking the electronic component from the first carrier and/or when placing the electronic component onto the second carrier;
a sensor system (241, 242) for sensing a position of an n-th order light beam from the diffraction grating, wherein |*n*| > 0; and
a processor (150) configured for determining a change in length of the pickup unit in the first direction at a position of the diffraction grating based on the sensed position of the n-th order light beam when picking an electronic component from the first carrier and/or when placing an electronic component onto the second carrier.

2. The pick-and-place apparatus according to claim 1, wherein the processor is further configured to determine, based on the determined change in length:
a first force exerted by the pickup unit on the electronic component and/or the first carrier when picking the electronic component from the first carrier; and/or
a second force exerted by the pickup unit on the electronic component and/or the second carrier when placing the electronic component onto the second carrier.

3. The pick-and-place apparatus according to claim 2, further comprising a movable support unit (160), such as a robotic arm, on which the pickup unit is mounted, wherein the processor is configured to:
adjust a force exerted by the movable support unit through the pickup unit on the electronic component and/or first carrier when picking the electronic component from the first carrier; and/or
adjust a force exerted by the movable support unit through the pickup unit on the electronic component and/or second carrier when placing the electronic component onto the second carrier.

4. The pick-and-place apparatus according to claim 3, wherein the processor is configured to:
determine the first force and/or the associated change in length during picking of an electronic component, compare the determined first force and/or the associated change in length to a first reference force and/or an associated first reference change in length, and generate a first comparison result; and/or
determine the second force and/or the associated change in length during placing of an electronic component, compare the determined second force and/or the associated change in length to a second reference force and/or an associated second reference change in length, and generate a second comparison result.

5. The pick-and-place apparatus according to claim 4, wherein the processor is configured to adjust, in dependence of the first comparison result and/or second comparison result:
said force exerted by the movable support unit through the pickup unit on the electronic component and/or first carrier when picking the electronic component from the first carrier; and/or
said force exerted by the movable support unit through the pickup unit on the electronic component and/or second carrier when placing the electronic component onto the second carrier.

6. The pick-and-place apparatus according to claim 4, wherein the processor is configured to output a signal in correspondence with the first and/or second comparison result to a user;
wherein the processor is configured to receive a user input for:
adjusting said force exerted by the movable support unit through the pickup unit on the electronic component and/or first carrier when picking the electronic component from the first carrier; and/or
adjusting said force exerted by the movable support unit through the pickup unit on the electronic component and/or second carrier when placing the electronic component onto the second carrier.

7. The pick-and-place apparatus according to any of the claims 4-6, further comprising a memory that is operatively coupled to the processor and that holds a look-up table that correlates a change in length of the pickup unit in the first direction at said position of the diffraction grating to a value of a force and/or strain exerted on the pickup unit associated with said length contraction.

8. The pick-and-place apparatus according to any of the previous claims, wherein the sensor system is further configured for sensing an m-th order light beam from the diffraction grating, wherein *m* is different from 0 and *n*; and
wherein the processor is configured for determining a change in length of the pickup unit in the first direction at a position of the diffraction grating based on the sensed n-th order light beam, and the sensed *m*-th order light beam when picking an electronic component from the first carrier and/or when placing an electronic component onto the second carrier;
wherein *m* is preferably equal to *-n,* and wherein *n* preferably equals 1;
wherein the processor is preferably configured to determine an orientation of the pickup unit when picking an electronic component from the first carrier and/or when placing an electronic component onto the second carrier based on the sensed *n*-th order light beam and the sensed *m*-th order light beam.

9. The pick-and-place apparatus according to any of the previous claims, wherein the sensor system is configured for sensing a 0-th order light beam from the diffraction grating; and
wherein the processor is configured for determining a change in length of the pickup unit in the first direction at a position of the diffraction grating based on the sensed 0-th order light beam, the sensed *n*-th order light beam, and the sensed *m*-th order light beam when picking an electronic component from the first carrier and/or when placing an electronic component onto the second carrier;
wherein the processor is preferably further configured to determine an orientation and position of the pickup unit when picking an electronic component from the first carrier and/or when placing an electronic component onto the second carrier based on the sensed 0-th order light beam, the sensed n-th order light beam, and the sensed m-th order light beam.

10. The pick-and-place apparatus according to claim 8 and/or claim 9, wherein the pick-and-place apparatus further comprises at least one orientation unit for changing an orientation of the at least one collimated light source, wherein the processor is configured for controlling the at least one orientation unit in dependence of the determined orientation and/or position for ensuring that light from the at least one collimated light source impinges the diffraction grating during picking of each of the plurality of electronic components to be picked from the first carrier, and/or for ensuring that light from the at least one collimated light source impinges the diffraction grating during placing of each of the plurality of electronic components to be placed onto the second carrier.

11. The pick-and-place apparatus according to any of the previous claims, wherein:
the first carrier is a semiconductor wafer or a carrier supporting that semiconductor wafer, and the electronic components to be placed and arranged are semiconductor dies from that semiconductor wafer, and wherein the second carrier is a printed circuit board; or
the electronic components are packaged semiconductor dies or devices.

12. The pick-and-place apparatus according to any of the previous claims, wherein the diffraction grating is a transmissive or a transparent diffraction grating.

13. The pick-and-place apparatus according to any of the previous claims, wherein the at least one collimated light source comprises a first collimated light source configured for emitting collimated light onto the diffraction grating when picking an electronic component from the first carrier, and a second collimated light source configured for emitting collimated light onto the diffraction grating when placing an electronic component onto the second carrier;
wherein the sensor system comprises a first sensor subsystem for sensing light beams from the diffraction grating when picking an electronic component from the first carrier, and a second sensor subsystem for sensing light beams from the diffraction grating when placing an electronic component onto the second carrier; and/or
wherein the sensor system, or the first and second sensor subsystems, each comprise a respective sensor for sensing a respective light beam among the 0-th order, m-th order, and n-th order from the diffraction grating.

14. A method for picking an electronic component (301) from a first carrier, comprising
picking, using a pickup unit (210), the electronic component from the first carrier, wherein an outer surface of the pickup unit is provided with a diffraction grating (211) that comprises a repetition, in a first direction, of a pattern unit;
emitting collimated light onto the diffraction grating when picking the electronic component from the first carrier;
sensing a position of an *n*-th order light beam from the diffraction grating, wherein |*n*| > 0; and
determining a change in length of the pickup unit in the first direction at a position of the diffraction grating based on the sensed position of the *n*-th order light beam when picking the electronic component from the first carrier.

15. A method for placing an electronic component (301) from a second carrier (302), comprising:
placing, using a pickup unit (210), the electronic component from the second carrier, wherein an outer surface of the pickup unit is provided with a diffraction grating (211) that comprises a repetition, in a first direction, of a pattern unit;
emitting collimated light onto the diffraction grating when placing the electronic component onto the second carrier;
sensing a position of an *n*-th order light beam from the diffraction grating, wherein |*n*| > 0;
and
determining a change in length of the pickup unit in the first direction at a position of the diffraction grating based on the sensed position of the *n*-th order light beam when placing the electronic component onto the second carrier.

## Patentansprüche

1. Aufnahme- und Platzierungsvorrichtung (200) zum Aufnehmen einer elektronischen Komponente (301) von einem ersten Träger und zum Platzieren der elektronischen Komponente auf einem zweiten Träger (302), wobei die Vorrichtung Folgendes umfasst:
eine Aufnahmeeinheit (210) zum Aufnehmen der elektronischen Komponente und zum Platzieren der elektronischen Komponente, wobei eine Außenfläche der Aufnahmeeinheit mit einem Beugungsgitter (211) versehen ist, das in einer ersten Richtung eine Wiederholung einer Mustereinheit umfasst;
mindestens eine Quelle für kollimiertes Licht, die dafür konfiguriert ist, kollimiertes Licht auf das Beugungsgitter zu emittieren, wenn die elektronische Komponente von dem ersten Träger aufgenommen wird und/oder wenn die elektronische Komponente auf dem zweiten Träger platziert wird;
ein Sensorsystem (241, 242) zum Abtasten einer Position eines Lichtstrahls *n*. Ordnung von dem Beugungsgitter, wobei |*n*| > 0 ist; und
einen Prozessor (150), der zum Bestimmen einer Veränderung der Länge der Aufnahmeeinheit in der ersten Richtung an einer Position des Beugungsgitters basierend auf der abgetasteten Position des Lichtstrahls *n*. Ordnung, wenn eine elektronische Komponente von dem ersten Träger aufgenommen wird und/oder wenn eine elektronische Komponente auf dem zweiten Träger platziert wird, konfiguriert ist.

2. Aufnahme- und Platzierungsvorrichtung nach Anspruch 1, wobei der Prozessor ferner dafür konfiguriert ist, basierend auf der bestimmten Veränderung der Länge Folgendes zu bestimmen:
eine erste Kraft, die von der Aufnahmeeinheit auf die elektronische Komponente und/oder den ersten Träger ausgeübt wird, wenn die elektronische Komponente von dem ersten Träger aufgenommen wird; und/oder
eine zweite Kraft, die von der Aufnahmeeinheit auf die elektronische Komponente und/oder den zweiten Träger ausgeübt wird, wenn die elektronische Komponente auf dem zweiten Träger platziert wird.

3. Aufnahme- und Platzierungsvorrichtung nach Anspruch 2, ferner umfassend eine bewegliche Stützeinheit (160), wie etwa einen Roboterarm, an den die Aufnahmeeinheit montiert ist, wobei der Prozessor für Folgendes konfiguriert ist:
Justieren einer Kraft, die von der beweglichen Stützeinheit durch die Aufnahmeeinheit auf die elektronische Komponente und/oder den ersten Träger ausgeübt wird, wenn die elektronische Komponente von dem ersten Träger aufgenommen wird; und/oder
Justieren einer Kraft, die von der beweglichen Stützeinheit durch die Aufnahmeeinheit auf die elektronische Komponente und/oder den zweiten Träger ausgeübt wird, wenn die elektronische Komponente auf dem zweiten Träger platziert wird.

4. Aufnahme- und Platzierungsvorrichtung nach Anspruch 3, wobei der Prozessor für Folgendes konfiguriert ist:
Bestimmen der ersten Kraft und/oder der zugehörigen Veränderung der Länge während des Aufnehmens einer elektronischen Komponente, Vergleichen der bestimmten ersten Kraft und/oder der zugehörigen Veränderung der Länge mit einer ersten Referenzkraft und/oder einer zugehörigen ersten Referenzveränderung der Länge und Erzeugen eines ersten Vergleichsergebnisses; und/oder
Bestimmen der zweiten Kraft und/oder der zugehörigen Veränderung der Länge während des Platzierens einer elektronischen Komponente, Vergleichen der bestimmten zweiten Kraft und/oder der zugehörigen Veränderung der Länge mit einer zweiten Referenzkraft und/oder einer zugehörigen zweiten Referenzveränderung der Länge und Erzeugen eines zweiten Vergleichsergebnisses.

5. Aufnahme- und Platzierungsvorrichtung nach Anspruch 4, wobei der Prozessor dafür konfiguriert ist, in Abhängigkeit von dem ersten Vergleichsergebnis und/oder dem zweiten Vergleichsergebnis Folgendes zu justieren:
die Kraft, die von der beweglichen Stützeinheit durch die Aufnahmeeinheit auf die elektronische Komponente und/oder den ersten Träger ausgeübt wird, wenn die elektronische Komponente von dem ersten Träger aufgenommen wird; und/oder
die Kraft, die von der beweglichen Stützeinheit durch die Aufnahmeeinheit auf die elektronische Komponente und/oder den zweiten Träger ausgeübt wird, wenn die elektronische Komponente auf dem zweiten Träger platziert wird.

6. Aufnahme- und Platzierungsvorrichtung nach Anspruch 4, wobei der Prozessor dafür konfiguriert ist, in Entsprechung zu dem ersten und/oder dem zweiten Vergleichsergebnis ein Signal an einen Benutzer auszugeben;
wobei der Prozessor dafür konfiguriert ist, eine Benutzereingabe für Folgendes zu empfangen:
Justieren der Kraft, die von der beweglichen Stützeinheit durch die Aufnahmeeinheit auf die elektronische Komponente und/oder den ersten Träger ausgeübt wird, wenn die elektronische Komponente von dem ersten Träger aufgenommen wird; und/oder
Justieren der Kraft, die von der beweglichen Stützeinheit durch die Aufnahmeeinheit auf die elektronische Komponente und/oder den zweiten Träger ausgeübt wird, wenn die elektronische Komponente auf dem zweiten Träger platziert wird.

7. Aufnahme- und Platzierungsvorrichtung nach einem der Ansprüche 4 bis 6, ferner umfassend einen Speicher, der funktionsmäßig mit dem Prozessor gekoppelt ist und der eine Nachschlagetabelle enthält, die eine Veränderung der Länge der Aufnahmeeinheit in der ersten Richtung an der Position des Beugungsgitters zu einem Wert für eine Kraft und/oder Belastung in Beziehung setzt, die auf die Aufnahmeeinheit in Zusammenhang mit der Längenkontraktion ausgeübt wird.

8. Aufnahme- und Platzierungsvorrichtung nach einem der vorhergehenden Ansprüche, wobei das Sensorsystem ferner dafür konfiguriert ist, einen Lichtstrahl *m*. Ordnung von dem Beugungsgitter abzutasten, wobei sich *m* von 0 und von *n* unterscheidet; und
wobei der Prozessor zum Bestimmen einer Veränderung der Länge der Aufnahmeeinheit in der ersten Richtung an einer Position des Beugungsgitters basierend auf dem abgetasteten Lichtstrahl *n*. Ordnung und dem abgetasteten Lichtstrahl *m*. Ordnung, wenn eine elektronische Komponente von dem ersten Träger aufgenommen wird und/oder wenn eine elektronische Komponente auf dem zweiten Träger platziert wird, konfiguriert ist,
wobei *m* vorzugsweise gleich -*n* ist und wobei *n* vorzugsweise gleich 1 ist;
wobei der Prozessor vorzugsweise dafür konfiguriert ist, basierend auf dem abgetasteten Lichtstrahl *n*. Ordnung und dem abgetasteten Lichtstrahl *m*. Ordnung eine Ausrichtung der Aufnahmeeinheit, wenn eine elektronische Komponente von dem ersten Träger aufgenommen wird und/oder wenn eine elektronische Komponente auf dem zweiten Träger platziert wird, zu bestimmen.

9. Aufnahme- und Platzierungsvorrichtung nach einem der vorhergehenden Ansprüche, wobei das Sensorsystem zum Abtasten eines Lichtstrahls 0. Ordnung von dem Beugungsgitter konfiguriert ist; und
wobei der Prozessor zum Bestimmen einer Veränderung der Länge der Aufnahmeeinheit in der ersten Richtung an einer Position des Beugungsgitters basierend auf dem abgetasteten Lichtstrahl 0. Ordnung, dem abgetasteten Lichtstrahl *n*. Ordnung und dem abgetasteten Lichtstrahl *m*. Ordnung, wenn eine elektronische Komponente von dem ersten Träger aufgenommen wird und/oder wenn eine elektronische Komponente auf dem zweiten Träger platziert wird, konfiguriert ist;
wobei der Prozessor vorzugsweise ferner dafür konfiguriert ist, basierend auf dem abgetasteten Lichtstrahl 0. Ordnung, dem abgetasteten Lichtstrahl *n*. Ordnung und dem abgetasteten Lichtstrahl *m*. Ordnung eine Ausrichtung und Position der Aufnahmeeinheit, wenn eine elektronische Komponente von dem ersten Träger aufgenommen wird und/oder wenn eine elektronische Komponente auf dem zweiten Träger platziert wird, zu bestimmen.

10. Aufnahme- und Platzierungsvorrichtung nach Anspruch 8 und/oder Anspruch 9, wobei die Aufnahme- und Platzierungsvorrichtung ferner mindestens eine Ausrichtungseinheit zum Verändern einer Ausrichtung der mindestens einen Quelle für kollimiertes Licht umfasst, wobei der Prozessor zum Steuern der mindestens einen Ausrichtungseinheit in Abhängigkeit von der bestimmten Ausrichtung und/oder Position konfiguriert ist, um zu gewährleisten, dass Licht von der mindestens einen Quelle für kollimiertes Licht während des Aufnehmens jeder der mehreren elektronischen Komponenten, die von dem ersten Träger aufzunehmen sind, auf das Beugungsgitter auftrifft, und/oder um zu gewährleisten, dass Licht von der mindestens einen Quelle für kollimiertes Licht während des Platzierens jeder der mehreren elektronischen Komponenten, die auf dem zweiten Träger zu platzieren sind, auf das Beugungsgitter auftrifft.

11. Aufnahme- und Platzierungsvorrichtung nach einem der vorhergehenden Ansprüche, wobei:
der erste Träger ein Halbleiter-Wafer oder ein Träger ist, der den Halbleiter-Wafer stützt, und die zu platzierenden und anzuordnenden elektronischen Komponenten Halbleiterchips von diesem Halbleiter-Wafer sind, und wobei der zweite Träger eine Leiterplatte ist; oder
die elektronischen Komponenten gehäuste Halbleiterchips oder -bauelemente sind.

12. Aufnahme- und Platzierungsvorrichtung nach einem der vorhergehenden Ansprüche, wobei das Beugungsgitter ein transmissives oder transparentes Beugungsgitter ist.

13. Aufnahme- und Platzierungsvorrichtung nach einem der vorhergehenden Ansprüche, wobei die mindestens eine Quelle für kollimiertes Licht eine erste Quelle für kollimiertes Licht, die zum Emittieren von kollimiertem Licht auf das Beugungsgitter, wenn eine elektronische Komponente von dem ersten Träger aufgenommen wird, konfiguriert ist, und eine zweite Quelle für kollimiertes Licht umfasst, die zum Emittieren von kollimiertem Licht auf das Beugungsgitter, wenn eine elektronische Komponente auf dem zweiten Träger platziert wird, konfiguriert ist;
wobei das Sensorsystem ein erstes Sensorteilsystem zum Abtasten von Lichtstrahlen von dem Beugungsgitter, wenn eine elektronische Komponente von dem ersten Träger aufgenommen wird, und ein zweites Sensorteilsystem zum Abtasten von Lichtstrahlen von dem Beugungsgitter, wenn eine elektronische Komponente auf dem zweiten Träger platziert wird, umfasst; und/oder
wobei das Sensorsystem oder das erste und das zweite Sensorteilsystem jeweils einen entsprechenden Sensor zum Abtrasten eines entsprechenden Lichtstrahls der 0. Ordnung, der *m*. Ordnung und der *n*. Ordnung von dem Beugungsgitter umfasst.

14. Verfahren zum Aufnehmen einer elektronischen Komponente (301) von einem ersten Träger, umfassend:
Aufnehmen der elektronischen Komponente von dem ersten Träger unter Verwendung einer Aufnahmeeinheit (210), wobei eine Außenfläche der Aufnahmeeinheit mit einem Beugungsgitter (211) versehen ist, das eine Wiederholung einer Mustereinheit in einer ersten Richtung umfasst;
Emittieren von kollimiertem Licht auf das Beugungsgitter, wenn die elektronische Komponente von dem ersten Träger aufgenommen wird;
Abtasten einer Position eines Lichtstrahls *n*. Ordnung von dem Beugungsgitter, wobei |*n*| > 0 ist; und
Bestimmen einer Veränderung der Länge der Aufnahmeeinheit in der ersten Richtung an einer Position des Beugungsgitters basierend auf der abgetasteten Position des Lichtstrahls *n*. Ordnung, wenn die elektronische Komponente von dem ersten Träger aufgenommen wird.

15. Verfahren zum Platzieren einer elektronischen Komponente (301) von einem zweiten Träger, umfassend:
Platzieren der elektronischen Komponente von dem zweiten Träger unter Verwendung einer Aufnahmeeinheit (210), wobei eine Außenfläche der Aufnahmeeinheit mit einem Beugungsgitter (211) versehen ist, das eine Wiederholung einer Mustereinheit in einer ersten Richtung umfasst;
Emittieren von kollimiertem Licht auf das Beugungsgitter, wenn die elektronische Komponente auf dem zweiten Träger platziert wird;
Abtasten einer Position eines Lichtstrahls *n*. Ordnung von dem Beugungsgitter, wobei |*n*| > 0 ist; und
Bestimmen einer Veränderung der Länge der Aufnahmeeinheit in der ersten Richtung an einer Position des Beugungsgitters basierend auf der abgetasteten Position des Lichtstrahls *n*. Ordnung, wenn die elektronische Komponente auf dem zweiten Träger platziert wird.

## Revendications

1. Machine de préhension et de positionnement (200) pour appréhender un composant électronique (301) à partir d'un premier support et pour positionner le composant électronique sur un second support (302), la machine comprenant :
une unité de préhension (210) pour appréhender le composant électronique et pour positionner le composant électronique, une surface externe de l'unité de préhension étant pourvue d'un réseau de diffraction (211) qui comprend une répétition, dans une première direction, d'une unité de motif ;
au moins une source de lumière collimatée configurée pour émettre une lumière collimatée sur le réseau de diffraction lors de la préhension du composant électronique à partir du premier support et/ou lors du positionnement du composant électronique sur le second support ;
un système de capteur (241, 242) pour détecter une position d'un faisceau lumineux d'ordre *n* provenant du réseau de diffraction, où |*n*| > 0 ; et
un processeur (150) configuré pour déterminer un changement de longueur de l'unité de préhension dans la première direction au niveau d'une position du réseau de diffraction sur la base de la position détectée du faisceau lumineux d'ordre *n* lors de la préhension d'un composant électronique à partir du premier support et/ou lors du positionnement d'un composant électronique sur le second support.

2. Machine de préhension et de positionnement selon la revendication 1, dans laquelle le processeur est en outre configuré pour déterminer, sur la base du changement de longueur déterminé :
une première force exercée par l'unité de préhension sur le composant électronique et/ou le premier support lors de la préhension du composant électronique à partir du premier support ;
et/ou
une seconde force exercée par l'unité de préhension sur le composant électronique et/ou le second support lors du positionnement du composant électronique sur le second support.

3. Machine de préhension et de positionnement selon la revendication 2, comprenant en outre une unité de support mobile (160), telle qu'un bras robotique, sur laquelle l'unité de préhension est montée, dans laquelle le processeur est configuré pour :
ajuster une force exercée par l'unité de support mobile à travers l'unité de préhension sur le composant électronique et/ou le premier support lors de la préhension du composant électronique à partir du premier support ; et/ou
ajuster une force exercée par l'unité de support mobile à travers l'unité de préhension sur le composant électronique et/ou le second support lors du positionnement du composant électronique sur le second support.

4. Machine de préhension et de positionnement selon la revendication 3, dans laquelle le processeur est configuré pour :
déterminer la première force et/ou le changement de longueur associé pendant la préhension d'un composant électronique, comparer la première force déterminée et/ou le changement de longueur associé à une première force de référence et/ou un premier changement de longueur de référence associé, et générer un premier résultat de comparaison ; et/ou
déterminer la seconde force et/ou le changement de longueur associé pendant le positionnement d'un composant électronique, comparer la seconde force déterminée et/ou le changement de longueur associé à une seconde force de référence et/ou un second changement de longueur de référence associé, et générer un second résultat de comparaison.

5. Machine de préhension et de positionnement selon la revendication 4, dans laquelle le processeur est configuré pour ajuster, en fonction du premier résultat de comparaison et/ou du second résultat de comparaison :
ladite force exercée par l'unité de support mobile à travers l'unité de préhension sur le composant électronique et/ou le premier support lors de la préhension du composant électronique à partir du premier support ; et/ou
ladite force exercée par l'unité de support mobile à travers l'unité de préhension sur le composant électronique et/ou le second support lors du positionnement du composant électronique sur le second support.

6. Machine de préhension et de positionnement selon la revendication 4, dans laquelle le processeur est configuré pour délivrer un signal en correspondance avec le premier et/ou le second résultat de comparaison à un utilisateur ;
dans laquelle le processeur est configuré pour recevoir une entrée d'utilisateur pour :
ajuster ladite force exercée par l'unité de support mobile à travers l'unité de préhension sur le composant électronique et/ou le premier support lors de la préhension du composant électronique à partir du premier support ; et/ou
ajuster ladite force exercée par l'unité de support mobile à travers l'unité de préhension sur le composant électronique et/ou le second support lors du positionnement du composant électronique sur le second support.

7. Machine de préhension et de positionnement selon l'une quelconque des revendications 4 à 6, comprenant en outre une mémoire qui est couplée de manière fonctionnelle au processeur et qui contient une table de correspondance qui corrèle un changement de longueur de l'unité de préhension dans la première direction au niveau d'une position du réseau de diffraction à une valeur d'une force et/ou d'une déformation exercée sur l'unité de préhension associée à ladite contraction de longueur.

8. Machine de préhension et de positionnement selon l'une quelconque des revendications précédentes, dans laquelle le système de capteur est en outre configuré pour détecter un faisceau lumineux d'ordre *m* provenant du réseau de diffraction, où *m* est différent de 0 et *n* ; et
dans laquelle le processeur est configuré pour déterminer un changement de longueur de l'unité de préhension dans la première direction au niveau d'une position du réseau de diffraction sur la base du faisceau lumineux d'ordre *n* détecté, et du faisceau lumineux d'ordre *m* détecté lors de la préhension d'un composant électronique à partir du premier support et/ou lors du positionnement d'un composant électronique sur le second support ;
dans laquelle *m* est de préférence égal à -*n*, et dans lequel *n* est de préférence égal à 1 ;
dans laquelle le processeur est de préférence configuré pour déterminer une orientation de l'unité de préhension lors de la préhension d'un composant électronique à partir du premier support et/ou lors du positionnement d'un composant électronique sur le second support sur la base du faisceau lumineux d'ordre *n* détecté et du faisceau lumineux d'ordre *m* détecté.

9. Machine de préhension et de positionnement selon l'une quelconque des revendications précédentes, dans laquelle le système de capteur est configuré pour détecter un faisceau lumineux d'ordre 0 provenant du réseau de diffraction ; et
dans laquelle le processeur est configuré pour déterminer un changement de longueur de l'unité de préhension dans la première direction au niveau d'une position du réseau de diffraction sur la base du faisceau lumineux d'ordre 0 détecté, du faisceau lumineux d'ordre *n* détecté, et du faisceau lumineux d'ordre *m* détecté lors de la préhension d'un composant électronique à partir du premier support et/ou lors du positionnement d'un composant électronique sur le second support ;
dans laquelle le processeur est de préférence en outre configuré pour déterminer une orientation et une position de l'unité de préhension lors de la préhension d'un composant électronique à partir du premier support et/ou lors du positionnement d'un composant électronique sur le second support sur la base du faisceau lumineux d'ordre 0 détecté, du faisceau lumineux d'ordre *n* détecté, et du faisceau lumineux d'ordre *m* détecté.

10. Machine de préhension et de positionnement selon la revendication 8 et/ou la revendication 9, dans laquelle la machine de préhension et de positionnement comprend en outre au moins une unité d'orientation pour modifier une orientation de l'au moins une source de lumière collimatée, dans laquelle le processeur est configuré pour commander l'au moins une unité d'orientation en fonction de l'orientation et/ou de la position déterminées pour garantir que la lumière provenant de l'au moins une source de lumière collimatée frappe le réseau de diffraction pendant la préhension de chacun de la pluralité de composants électroniques à appréhender à partir du premier support, et/ou pour garantir que la lumière provenant de l'au moins une source de lumière collimatée frappe le réseau de diffraction pendant le positionnement de chacun de la pluralité de composants électroniques à positionner sur le second support.

11. Machine de préhension et de positionnement selon l'une quelconque des revendications précédentes, dans laquelle :
le premier support est une tranche de semi-conducteur ou un support supportant cette tranche de semi-conducteur, et les composants électroniques à positionner et à agencer sont des puces de semi-conducteur provenant de cette tranche de semi-conducteur, et dans laquelle le second support est une carte de circuit imprimé ; ou
les composants électroniques sont des puces ou des dispositifs de semi-conducteurs encapsulés.

12. Machine de préhension et de positionnement selon l'une quelconque des revendications précédentes, dans laquelle le réseau de diffraction est un réseau de diffraction transmissif ou un réseau de diffraction transparent.

13. Machine de préhension et de positionnement selon l'une quelconque des revendications précédentes, dans laquelle l'au moins une source de lumière collimatée comprend une première source de lumière collimatée configurée pour émettre une lumière collimatée sur le réseau de diffraction lors de la préhension d'un composant électronique à partir du premier support, et une seconde source de lumière collimatée configurée pour émettre une lumière collimatée sur le réseau de diffraction lors du positionnement d'un composant électronique sur le second support ;
dans laquelle le système de capteur comprend un premier sous-système de capteur pour détecter des faisceaux lumineux provenant du réseau de diffraction lors de la préhension d'un composant électronique à partir du premier support, et un second sous-système de capteur pour détecter des faisceaux lumineux provenant du réseau de diffraction lors du positionnement d'un composant électronique sur le second support ; et/ou
dans laquelle le système de capteur, ou les premier et second sous-systèmes de capteur, comprennent chacun un capteur respectif pour détecter un faisceau lumineux respectif parmi un faisceau lumineux d'ordre 0, d'ordre *m* et d'ordre *n* provenant du réseau de diffraction.

14. Procédé pour appréhender un composant électronique (301) à partir d'un premier support, comprenant :
la préhension, à l'aide d'une unité de préhension (210), du composant électronique à partir du premier support, une surface externe de l'unité de préhension étant pourvue d'un réseau de diffraction (211) qui comprend une répétition, dans une première direction, d'une unité de motif ;
l'émission d'une lumière collimatée sur le réseau de diffraction lors de la préhension du composant électronique à partir du premier support ;
la détection d'une position d'un faisceau lumineux d'ordre *n* provenant du réseau de diffraction, où |*n*| > 0 ; et
la détermination d'un changement de longueur de l'unité de préhension dans la première direction au niveau d'une position du réseau de diffraction sur la base de la position détectée du faisceau lumineux d'ordre *n* lors de la préhension du composant électronique à partir du premier support.

15. Procédé de positionnement d'un composant électronique (301) à partir d'un second support (302), comprenant :
le positionnement, à l'aide d'une unité de préhension (210), du composant électronique à partir du second support, une surface externe de l'unité de préhension étant pourvue d'un réseau de diffraction (211) qui comprend une répétition, dans une première direction, d'une unité de motif ;
l'émission d'une lumière collimatée sur le réseau de diffraction lors du positionnement du composant électronique sur le second support ;
la détection d'une position d'un faisceau lumineux d'ordre *n* provenant du réseau de diffraction, où |*n*| > 0 ; et
la détermination d'un changement de longueur de l'unité de préhension dans la première direction au niveau d'une position du réseau de diffraction sur la base de la position détectée du faisceau lumineux d'ordre *n* lors du positionnement du composant électronique sur le second support.
